# EUROPEAN PATENT APPLICATION

(11) **EP 4 506 800 A1**
(43) Date of publication of application: **12.02.2025**
(21) Application number: 24191743.4
(22) Date of filing: 30.07.2024
(51) Int. Cl.: G06F 3/04815, G06F 3/04842, G06F 3/04845, G06F 3/01, G06F 30/13, G06Q 50/08, G06T 17/00, E04B 1/94, E04B 2/74

(54) **VR EXPERIENCE SYSTEM AND METHOD FOR CONSTRUCTION SPACE**

(30) Priority: 11.08.2023 US 202363532104 P
(71) Applicant: Chou, Vicki-Fen, Zhongli Taoyuan City 320 (TW); Trinh, Philip, Zhongli Taoyuan City 320 (TW); Trinh, Christine, Zhongli Taoyuan City 320 (TW)
(72) Inventor: CHOU, Song, 320 Taoyuan City (TW)
(74) Representative: Charrier Rapp & Liebau

(57) **Abstract**

A VR experience system (1) for construction space includes: a virtual object database (15) for storing a plurality of virtual objects (101, 102, 103, 104); a virtual object controlling module (11) for receiving an operating instruction of a service provider (2); a virtual object selecting module (12) for executing the operating instruction of the service provider (2) and selecting the virtual objects (101, 102, 103, 104) from the virtual object database (15); a virtual object generating module (13) for generating a virtual space (110) and generating the virtual objects (101, 102, 103, 104) in the virtual space (110); and a virtual object displaying module (14) for displaying the virtual space (110) and the virtual objects (101, 102, 103, 104).

## Description

### BACKGROUND OF THE INVENTION

### FIELD OF THE INVENTION

The present disclosure relates to a construction space system and method, and more particularly to a construction space system and method through VR experience.

### DESCRIPTION OF THE PRIOR ART

Conventional construction and interior design did not enable users to experience the actual perception of any constructed buildings and indoor spaces before their construction work is physically completed. However, owing to technology advancement in recent years, the fields of construction, interior design and renovation rely to the integration of computer-aided design (CAD) and 3D virtual reality to assist architects, interior designers and consumers in planning and designing construction and renovation in a virtual environment so as for the consumers to understand the profile of interior design through a remote end of a computer device.

However, many consumers still think the aforesaid conventional integration of computer-aided design (CAD) and 3D virtual reality presents less most-direct perception to viewers than computer devices. Owing to 3D virtual reality (VR) technology advancement in recent years, interior designers start to use the integration of the technology of generating, moving and interacting with 3D virtual objects. The technology of generating 3D virtual objects through CAD to produce 3D virtual reality animations with a view enables the consumers to interact with 3D virtual objects in a 3D virtual space in real time and thereby enhance the consumers' virtual reality experience.

Despite the aforesaid technological advancement in VR technology and computer-aided interior design, there is still room for improvement in using VR experience, 3D virtual space, construction & renovation and 3D virtual object technology to provide real, rich and interactive virtual reality experience to a greater extent, enable users to build indoor or outdoor spaces in terms of styles more quickly, and allow users to carry out renovation and configuration in a virtual environment in real time.

### SUMMARY OF THE INVENTION

Therefore, to address the aforesaid issues, the disclosure provides a VR experience system for construction space, the system comprising: a virtual object database for storing a plurality of virtual objects; a virtual object controlling module for receiving an operating instruction of a service provider; a virtual object selecting module for executing the operating instruction of the service provider and selecting the virtual objects from the virtual object database; a virtual object generating module for generating a virtual space and generating the virtual objects in the virtual space; and a virtual object displaying module for displaying the virtual space and the virtual objects, wherein the virtual object selecting module receives a style description provided by the service provider through the operating instruction and obtains the virtual objects stored in the virtual object database and associated with the style description, and the service provider provides an indoor data or building data to the virtual object generating module through the operating instruction, allowing the virtual object generating module to generate the virtual space according to the indoor data or building data.

The disclosure further provides a VR experience system for construction space, wherein the virtual object controlling module receives the operating instruction of the service provider, and the operating instruction instructs deleting the virtual objects generated and re-selecting the virtual objects. The virtual objects of the virtual object database include a plurality of table objects, a plurality of sofa objects, a plurality of tile objects or a plurality of cabinet objects. The virtual objects correspond to a plurality of style groups, and the virtual object selecting module selects the virtual objects corresponding to each of the style groups according to a style description provided through the operating instruction of the service provider. The style description is generated according to a text or a reference picture, and the virtual object selecting module interprets the text or the reference picture to select the virtual objects corresponding to the style groups.

The disclosure yet further provides a VR experience system for construction space, wherein the indoor data comprises a dimension data and a space description. The system further comprises a VR device with which a user inspects the virtual objects and the virtual space generated by the virtual object displaying module. The system further comprises a VR device connected to an Internet through which a user inspects the virtual objects and the virtual space generated by the virtual object displaying module.

The disclosure still yet further provides a VR experience method for construction space, the method comprising the steps of: storing a plurality of virtual objects in a virtual object database; receiving an operating instruction of a service provider by a virtual object controlling module; executing the operating instruction of the service provider and selecting the virtual objects from the virtual object database by a virtual object selecting module; generating a virtual space and generating the virtual objects in the virtual space by a virtual object generating module; and displaying the virtual space and the virtual objects by a virtual object displaying module, wherein the virtual object selecting module receives a style description provided through the operating instruction of the service provider and retrieves from the virtual object database the virtual objects associated with the style description, and the operating instruction of the service provider provides an indoor data to the virtual object generating module, allowing the virtual object generating module to generate the virtual space according to the indoor data.

The disclosure still yet further provides a VR experience method for construction space, further comprising receiving the operating instruction of the service provider by the virtual object controlling module, and the operating instruction instructs deleting the virtual objects generated and re-selecting the virtual objects. The virtual objects of the virtual object database include a plurality of table objects, a plurality of sofa objects, a plurality of tile objects or a plurality of cabinet objects. The virtual objects correspond to a plurality of style groups, and the method further comprises receiving a style description provided through the operating instruction of the service provider and selecting the virtual objects corresponding to the style groups by the virtual object selecting module. The style description is generated according to a text or a reference picture, and the method further comprises interpreting the text or the reference picture and selecting the virtual objects corresponding to the style groups by the virtual object selecting module.

In conclusion, the disclosure provides a VR experience system and method for construction space to define virtual objects generated in a virtual space, through service providers' design and operation and through a style description and indoor data, allowing users to not only watch the virtual space with a VR device but also change the virtual objects in the virtual space. The disclosure is not only applicable to the fields of construction, renovation, and interior design but also applicable to setting up construction material or furniture retail platforms or services, working along with various supplier sales channels, and providing consumers with a remote-end watching and buying experience.

### BRIEF DESCRIPTION OF THE DRAWINGS

FIG. 1 is a block diagram of a VR experience system for construction space according to the disclosure.
FIG. 2 is a schematic view of a virtual object database of the VR experience system for construction space according to an embodiment of the disclosure.
FIG. 3 is a schematic view of how a user acquires VR experience through the VR experience system for construction space according to an embodiment of the disclosure.
FIG. 4 is a schematic view of a process flow of a method for the VR experience system for construction space according to the disclosure.
FIG. 5 is another block diagram of the VR experience system for construction space according to the disclosure.
FIG. 6 is a schematic view of how another user acquires remote-connection VR experience through the VR experience system for construction space according to an embodiment of the disclosure.
FIG. 7 is a schematic view of style description performed by the VR experience system for construction space according to an embodiment of the disclosure.

### DETAILED DESCRIPTION OF THE EMBODIMENTS

Objectives, features, and advantages of the disclosure are herein illustrated with specific embodiments, depicted with drawings, and described below. It is noteworthy that the specific embodiments are illustrative of the disclosure rather than restrictive of the scope of the disclosure.

The disclosure is depicted by drawings, illustrated by specific exemplary embodiments, and described below. The disclosure can be specifically implemented in many different forms, and thus the subject matters covered or claimed by the disclosure is not restrictive to any specific exemplary embodiments of the disclosure; thus, the specific exemplary embodiments of the disclosure merely serve exemplary purposes. Similarly, the disclosure provides reasonably broad scope to the subject matters covered or claimed by the disclosure. In addition, the claimed subject matters can be specifically implemented as a method, device or system. Therefore, the specific embodiments can be presented, for example, in the form of hardware, software, firmware or any combination thereof (known to be not software).

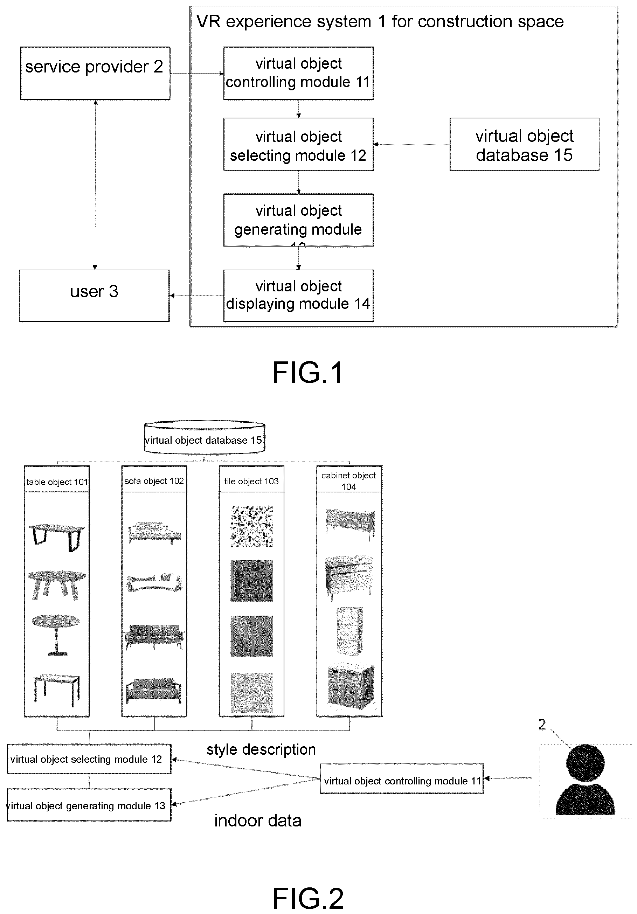

Referring to FIG. 1, there is shown a block diagram of a VR experience system 1 for construction space according to the disclosure. The VR experience system 1 for construction space receives a request from a service provider 2 to allow the service provider 2 to operate a virtual object controlling module 11 of the VR experience system 1 for construction space through a user operation interface by inputting thereto an operating instruction. In a specific embodiment, the operating instruction includes defining a virtual space 110, adjusting virtual objects in the virtual space 110, as well as generating, adjusting and selecting the virtual objects. The service provider 2 provides indoor data so as to define the virtual space 110 and provides a style description so as to obtain virtual objects.

The indoor data is either input by the service provider 2 or partially input and stored in a virtual object database 15 of the VR experience system 1 for construction space. The indoor data in the virtual object database 15 is read in order to define the virtual space 110. The virtual object database 15 stores virtual object data uploaded by multiple design companies, including data's basic description, most illustrative diagram, usage rules, authorization status, and files generated through computer-aided design (CAD) and presented in a specific format. The design companies include furniture design companies, interior design companies, and designers and can upload the designed virtual object to the virtual object database 15 under related rules.

The virtual object database 15 classifies, under storage rules, the virtual objects by the purposes defined by the design companies, into different classes, such as tables, sofas, tiles, and cabinets, but the disclosure is not limited thereto. For example, the aforesaid classes may also include virtual objects, such as lamps, kitchenware, decorations, curtains, wallpaper and stone materials. Design elements, for example, color, environment, function, and style name, of each of the uploaded virtual objects can be defined, such that different style groups for the virtual objects can be established. The virtual object database 15 also stores plenty of virtual objects for the service provider 2 to choose from, and the virtual objects correspond to different style groups respectively and different style designs respectively to allow the service provider 2 to quickly set up anticipated interior designs.

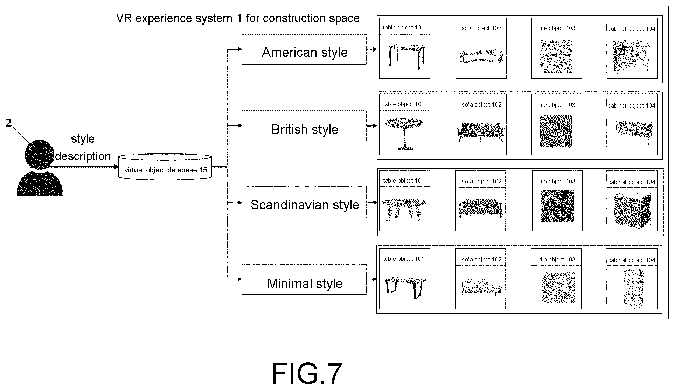

In a specific embodiment illustrated by FIG. 7 and related to style descriptions, the specified scene is a living room in which the virtual objects include table objects 101, sofa objects 102, tile objects 103, and cabinet objects 104 and the style groups thereof are divided into, namely American style, British style, Scandinavian style and Minimal style. When the VR experience system 1 for construction space receives a (Scandinavian) style description (for example, a text description about related design elements) input by the service provider 2 through the operating instruction, a virtual object selecting module 12 of the VR experience system 1 for construction space retrieves from the virtual object database 15 the table objects 101, sofa objects 102, tile objects 103, and cabinet objects 104 of Scandinavian style. The virtual object selecting module 12 selects virtual objects by feature descriptions or keywords (for example, hashtags) of the virtual objects stored in the virtual object database 15. Such that selected virtual objects are regarded as potential virtual objects of style descriptions to be sorted by the virtual object selecting module 12. The feature descriptions or keywords of the virtual objects are determined by suppliers; for example, when the suppliers upload the well-constructed virtual objects to the virtual object database 15, basic information about the virtual objects, such as feature descriptions or keywords, can be edited. For instance, the feature description or keywords of a furniture virtual object include but are not limited to designer name, design company, material, design element and design vocabulary. The virtual object selecting module 12 transfers the selected virtual objects to a virtual object generating module 13 of the VR experience system 1 for construction space to undergo a generation process.

According to the disclosure, the virtual object database 15 is configured to perform style classification or style grouping on virtual objects according to specific styles, and the style classification is defined by the service provider 2 or defined by the system according to the information of the virtual objects. For instance, virtual objects in a white background can be classified as Minimal style, including creamy white Minimal style table objects 101, white sleeper sofa objects 102, marble tile objects 103 and creamy white cabinet objects 104; however, the disclosure is not limited thereto, as Minimal style may also be applicable to any other types of virtual objects, including floor lamps, plant decorations, and white gauze curtains (not shown and further discussed herein). In addition to being defined by the service provider 2 in the virtual object database 15 of the system, the style classes or style groups are further defined by suppliers (i.e., architects and interior designers) of the virtual objects (for example, by setting a keyword and a hashtag), diversifying the style classification of the virtual object database 15 to a greater extent.

The virtual object selecting module 12 receives a style description from the service provider 2. The style description is defined and generated according to a text content or a reference picture content presented as a result of the envisagement of a VR environment by the service provider 2 or the user 3, for example, a passage of text description or an interior design photo. The virtual object selecting module 12 interprets the text content and picture content and retrieves therefrom one or more design elements. In another embodiment, the virtual object selecting module 12 comprises a semantic analysis model and an image recognition model and uses the trained semantic analysis model or image recognition model to perform the recognition of the style description provided by the service provider 2.

The virtual object generating module 13 receives the virtual objects selected by the virtual object selecting module 12, receives the indoor data (comprising specific dimension data and space description, with the dimension data being, for example, indicative of the inner length, width and height of the space, and the space description being, for example, descriptive of living rooms, bedrooms, kitchens, or positions of beams and columns and positions of doors) provided by the service provider 2 through the virtual object controlling module 11, and generates the virtual space 110 and virtual objects specified. Upon completion of the generation of the virtual space 110 which contains the virtual objects, the virtual space 110 is displayed by a virtual object displaying module 14 of the VR experience system 1 for construction space and thus can be watched by the user 3 through a VR device.

Upon completion of the generation of the virtual space 110 and the virtual objects, the service provider 2 gives the operating instruction and uses the virtual object controlling module 11 to instruct deleting the virtual objects generated and re-selecting the virtual objects. In a specific embodiment, since the user 3 dislikes British style cabinet objects 104 and tile objects 103, the service provider 2 deletes the British style cabinet objects 104 and tile objects 103 and selects from the virtual object database 15 Scandinavian style cabinet objects 104 and tile objects 103 for replacement.

In a specific embodiment, the virtual space 110 to be set up is a living room. Referring to FIG. 2, there is shown a schematic view of the virtual object database 15 of the VR experience system 1 for construction space according to an embodiment of the disclosure, and the virtual objects are selected by the virtual object selecting module 12 from object sets of different types, for example, including but not limited to the table objects 101, sofa objects 102, tile objects 103, and cabinet objects 104. The virtual object selecting module 12 receives a style description from the service provider 2. The virtual object selecting module 12 interprets text content and picture content in the style description and selects therefrom one or more design elements. The virtual object generating module 13 receives indoor data from the service provider 2 and generates the specified virtual space 110 and the virtual objects selected by the virtual object selecting module 12 according to the style description.

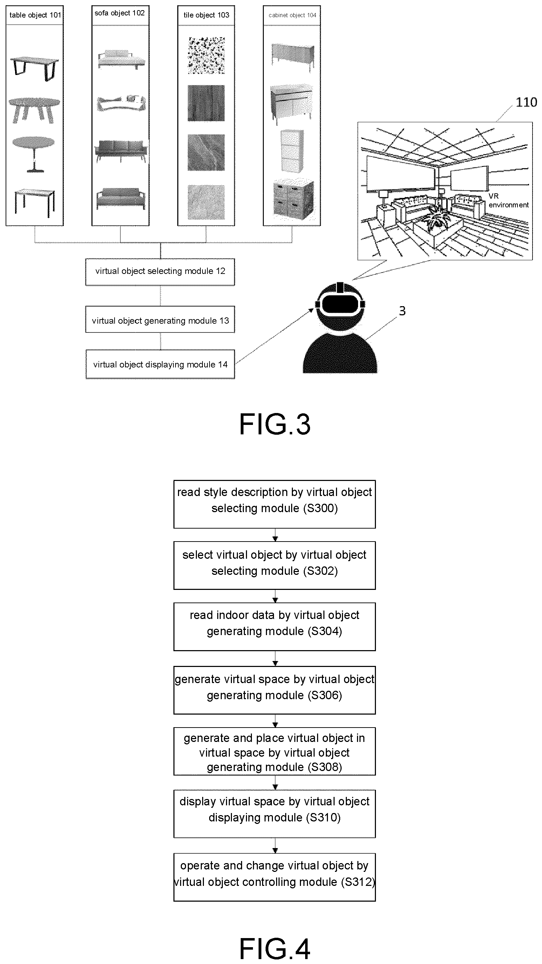

Referring to FIG. 3, there is shown a schematic view of how a user 3 acquires VR experience through the VR experience system 1 for construction space according to an embodiment of the disclosure. The virtual object generating module 13 generates the virtual space 110 specified and combines the virtual objects selected by the virtual object selecting module 12; the virtual space 110 and the virtual objects thus generated may be presented in various combinations. In a specific embodiment, the virtual space 110 shows other furniture objects, for example, posters and hanging scrolls hung on the wall, potted plants placed on the table objects 101, pendants, and TV sets placed on the cabinet objects 104.

The virtual object displaying module 14 of the VR experience system 1 for construction space displays the virtual space 110 so as for the user 3 to inspect the virtual space 110 through the VR device, allowing the user 3 to experience and preview the effect of indoor renovation through the VR environment. When the user 3 finds adjustment or replacement necessary in the course of watching indoor renovation, the user 3 can communicate with the service provider 2, operate the virtual object controlling module 11 of the VR experience system 1 for construction space, and delete the generated virtual objects and re-select the to-watch virtual objects through the operating instruction. In a variant embodiment, the user 3 and the service provider 2 are the same person.

Referring to FIG. 4, there is shown a schematic view of a process flow of a method for the VR experience system 1 for construction space according to the disclosure. The virtual object controlling module 11 of the VR experience system 1 for construction space provides the operating instruction to be input by the service provider 2 to execute step S300, allowing the virtual object selecting module 12 to obtain a style description input by the service provider 2 and related to the VR environment. For example, a text file descriptive of the VR environment must state a visual effect, function, style name, layout, and/or objects. Alternatively, anticipated styles are presented in a reference photo file. Alternatively, the service provider 2 generates a generative pre-trained transformer (GPT) and thereby generates a required style description, i.e., transforming and inputting a style description through GPT technology.

Step S302 involves selecting a virtual object from the virtual object database 15 according to object classification and a style description by the virtual object selecting module 12. For instance, regarding a style description about sharpness, the virtual object selecting module 12 recognizes one or more virtual objects according to design elements defined in virtual objects, and the one or more virtual objects thus selected may have design elements with sharp or right-angled corners. When the virtual object selecting module 12 selects multiple virtual objects, the virtual objects can be sorted according to their correlation with a style description.

Step S304 involves reading, by the virtual object generating module 13, indoor data inputted by the service provider 2. For example, specific CAD files are uploaded to the virtual object generating module 13. The virtual object generating module 13 recognizes specific dimension data and space description marked on a CAD model, with the dimension data being, for example, indicative of the inner length, width and height of the space, and the space description being, for example, descriptive of living rooms, bedrooms, kitchens, or positions of beams and columns and positions of doors. Step S306 involves generating the virtual space 110 by the virtual object generating module 13. The virtual space 110 comprises a space defined by a flooring, a ceiling and walls, rooms, corridors, passages and staircases. The indoor data relates to the area, shape and dimensions of the flooring, ceiling and walls.

S308 involves generating and placing the virtual objects in the virtual space 110 by the virtual object generating module 13, wherein the virtual objects in the virtual space 110 do not interfere with each other but are located at appropriate positions respectively. For example, sofa objects are generated and placed in a living room, and wallpaper is generated and affixed to walls. A layout involving one or more positions is generated according to the style description. For example, studio-related style descriptions are different from residence-related style descriptions in terms of the generated sense of space. The service provider 2 makes adjustment and selection at will through the virtual object controlling module 11.

Step S310 involves displaying the virtual space 110 by the virtual object displaying module 14, wherein the virtual space 110 is displayed by the virtual object displaying module 14 of the VR experience system 1 for construction space and inspected by the user 3 through the VR device, allowing the user 3 to experience and preview the effect of indoor renovation through the VR environment. In step S312, when the user 3 finds adjustment or replacement necessary in the course of watching indoor renovation, the user 3 can communicate with the service provider 2, operate the virtual object controlling module 11 of the VR experience system 1 for construction space, and delete the generated virtual objects and re-select the to-watch virtual objects through the operating instruction. For example, wallpaper objects or tile objects are replaced by those of other styles. Alternatively, the service provider 2 not only modifies style descriptions but also re-generates and places virtual objects in the virtual space 110 (i.e., repeating steps S300 ~ S310). In a variant embodiment, the user 3 and the service provider 2 are the same person.

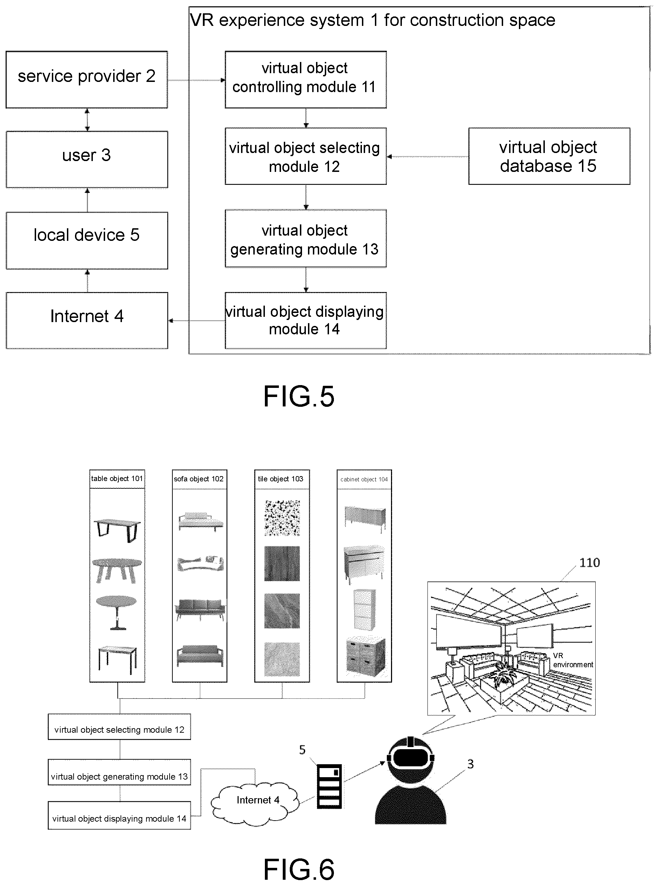

Referring to FIG. 5, there is shown another block diagram of the VR experience system 1 for construction space according to the disclosure. According to the disclosure, the VR experience system 1 for construction space enables the user 3 to connect to an Internet 4 through a local device 5 as well as watch the effect of indoor renovation provided by the VR experience system 1 for construction space from a remote end through the VR device.

Referring to FIG. 6, there is shown a schematic view of how another user acquires remote-connection VR experience through the VR experience system 1 for construction space according to an embodiment of the disclosure. The virtual object generating module 13 generates the virtual space 110 specified and combines the virtual objects selected by the virtual object selecting module 12; the virtual space 110 and the virtual objects thus generated may be presented in various combinations. At a remote end, the user 3 can wear a VR device, use the local device 5, connect the VR experience system 1 for construction space through the Internet 4, and inspect the displaying effect of the virtual object displaying module 14 of the VR experience system 1 for construction space on indoor renovation of the virtual space 110. When the user 3 finds adjustment or replacement necessary in the course of watching indoor renovation, the user 3 can communicate with the service provider 2, operate the virtual object controlling module 11 of the VR experience system 1 for construction space, and delete the generated virtual objects and re-select the to-watch virtual objects through the operating instruction. In a variant embodiment, the user 3 and the service provider 2 are the same person.

The aforesaid embodiments merely illustrate some aspects of the implementation of the disclosure through specific, detailed description but cannot be interpreted in such a way to limit the scope of the claims of the disclosure. It is noteworthy that persons skilled in the art can modify and improve the aforesaid embodiments without departing from concepts embodied in the disclosure, and the modification and improvement shall be deemed falling within the scope of the claims of the disclosure. Accordingly, the legal protection for the disclosure shall be defined by the appended claims.

## Claims

1. A VR experience system (1) for construction space, the system comprising:
a virtual object database (15) for storing a plurality of virtual objects (101, 102, 103, 104);
a virtual object controlling module (11) for receiving an operating instruction of a service provider (2);
a virtual object selecting module (12) for executing the operating instruction of the service provider (2) and selecting the virtual objects (101, 102, 103, 104) from the virtual object database (15);
a virtual object generating module (13) for generating a virtual space (110) and generating the virtual objects (101, 102, 103, 104) in the virtual space (110); and
a virtual object displaying module (14) for displaying the virtual space (110) and the virtual objects (101, 102, 103, 104),
wherein the virtual object selecting module (12) receives a style description provided by the service provider (2) through the operating instruction and obtains the virtual objects (101, 102, 103, 104) stored in the virtual object database (15) and associated with the style description, and the service provider (2) provides an indoor data to the virtual object generating module (13) through the operating instruction, allowing the virtual object generating module (13) to generate the virtual space (110) according to the indoor data.

2. The VR experience system (1) for construction space according to claim 1, wherein the virtual object controlling module (11) receives the operating instruction of the service provider (2), and the operating instruction instructs deleting the virtual objects (101, 102, 103, 104) generated and re-selecting the virtual objects (101, 102, 103, 104).

3. The VR experience system (1) for construction space according to claim 1, wherein the virtual objects (101, 102, 103, 104) of the virtual object database (15) include a plurality of table objects (101), a plurality of sofa objects (102), a plurality of tile objects (103) or a plurality of cabinet objects (104).

4. The VR experience system (1) for construction space according to claim 3, wherein the virtual objects (101, 102, 103, 104) correspond to a plurality of style groups, and the virtual object selecting module (12) selects the virtual objects (101, 102, 103, 104) corresponding to each of the style groups according to a style description provided through the operating instruction of the service provider (2).

5. The VR experience system (1) for construction space according to claim 4, wherein the style description is generated according to a text or a reference picture, and the virtual object selecting module (12) interprets the text or the reference picture to select the virtual objects (101, 102, 103, 104) corresponding to the style groups.

6. The VR experience system (1) for construction space according to claim 1, wherein the indoor data comprises a dimension data and a space description.

7. The VR experience system (1) for construction space according to claim 1, further comprising a VR device with which a user (3) inspects the virtual objects (101, 102, 103, 104) and the virtual space (110) generated by the virtual object displaying module (14).

8. The VR experience system (1) for construction space according to claim 1, further comprising a VR device connected to an Internet (4) through which a user (3) inspects the virtual objects (101, 102, 103, 104) and the virtual space (110) generated by the virtual object displaying module (14).

9. A VR experience method for construction space, the method comprising the steps of:
storing a plurality of virtual objects (101, 102, 103, 104) in a virtual object database (15);
receiving an operating instruction of a service provider (2) by a virtual object controlling module (11);
executing the operating instruction of the service provider (2) and selecting the virtual objects (101, 102, 103, 104) from the virtual object database (15) by a virtual object selecting module (12);
generating a virtual space (110) and generating the virtual objects (101, 102, 103, 104) in the virtual space (110) by a virtual object generating module (13); and
displaying the virtual space (110) and the virtual objects (101, 102, 103, 104) by a virtual object displaying module (14);
wherein the virtual object selecting module (12) receives a style description provided through the operating instruction of the service provider (2) and retrieves from the virtual object database (15) the virtual objects (101, 102, 103, 104) associated with the style description, and the operating instruction of the service provider (2) requires an indoor data to be provided to the virtual object generating module (13), allowing the virtual object generating module (13) to generate the virtual space (110) according to the indoor data.

10. The VR experience method for construction space according to claim 9, further comprising receiving the operating instruction of the service provider (2) by the virtual object controlling module (11), and the operating instruction instructs deleting the virtual objects (101, 102, 103, 104) generated and re-selecting the virtual objects (101, 102, 103, 104).

11. The VR experience method for construction space according to claim 9, wherein the virtual objects (101, 102, 103, 104) of the virtual object database (15) include a plurality of table objects (101), a plurality of sofa objects (102), a plurality of tile objects (103) or a plurality of cabinet objects (104).

12. The VR experience method for construction space according to claim 11, wherein the virtual objects (101, 102, 103, 104) correspond to a plurality of style groups, and the method further comprises receiving a style description provided through the operating instruction of the service provider (2) and selecting the virtual objects (101, 102, 103, 104) corresponding to the style groups by the virtual object selecting module (12).

13. The VR experience method for construction space according to claim 12, wherein the style description is generated according to a text or a reference picture, and the method further comprises interpreting the text or the reference picture and selecting the virtual objects (101, 102, 103, 104) corresponding to the style groups by the virtual object selecting module (12).
